Europäisches Patentamt

European Patent Office

Office européen des brevets

(11) Veröffentlichungsnummer: **0 304 593**
**A1**

## (12) EUROPÄISCHE PATENTANMELDUNG

(21) Anmeldenummer: **88111061.3**

(22) Anmeldetag: **11.07.88**

(51) Int. Cl.4: **H01F 15/10**

(30) Priorität: **24.08.87 DE 3728198**

(43) Veröffentlichungstag der Anmeldung:
**01.03.89 Patentblatt 89/09**

(84) Benannte Vertragsstaaten:
**AT BE CH DE FR GB IT LI NL SE**

(71) Anmelder: **Siemens Aktiengesellschaft Berlin
und München
Wittelsbacherplatz 2
D-8000 München 2(DE)**

(72) Erfinder: **Vojta, Erich
Melchiorstrasse 10
D-8000 München 71(DE)**
Erfinder: **Ehrgott, Roland
Quiddestrasse 68
D-8000 München 83(DE)**

(54) **SMD-Baustein.**

(57) Bei einem SMD-Baustein (B) mit mindestens einem Anschlußelement (Ae) und mindestens einem daran ankontaktierten Anschlußdraht (Ad) wird eine einfache und sichere elektrisch leitende Verbindung dadurch erreicht, daß
- das Anschlußelement (Ae) im Endbereich zu einer U-förmigen Lasche (UL) zurückgebogen ist,
- der Anschlußdraht (Ad) in der U-förmigen Lasche (UL) klemmend gehalten ist und daß
- im stirnseitigen Bereich der U-förmigen Lasche (UL) die Verbindung durch eine Schweißung (S) hergestellt ist.

Die Herstellung der Verbindungen kann leicht automatisiert werden. Anwendungen ergeben sich für alle SMD-Bausteine mit Anschlußdrähten (Ad), insbesondere für E-Kern-Übertrager, Schalenkernspulen, Transformatoren, Drosseln und dergleichen.

FIG 4

EP 0 304 593 A1

## SMD-Baustein

Die Erfindung betrifft einen SMD-Baustein mit mindestens einem Anschlußelement und mindestens einem an das Anschlußelement ankontaktierten Anschlußdraht.

Der Wunsch nach der Verkleinerung von Leiterplatten führte dazu, daß die Oberflächenmontage von Bauelementen, wie sie schon bei Schichtschaltungen seit langem üblich ist, nun auch zunehmend bei Leiterplatten zur Anwendung kommt.

Dabei werden die oberflächenlötbaren Bauelemente, die entsprechend dem englischsprachigen Begriff "Surface Mounted Devices" auch kurz SMDs genannt werden, nicht mehr in die Löcher der Platinen gesteckt, sondern auf deren Oberfläche aufgelötet. Sie benötigen 30 % bis 60 % weniger Platz. Da sich natürlich auch die Zahl der Durchkontaktierungen verringert, kann insgesamt mit einer Kostenreduzierung im Bereich von etwa 50 % gerechnet werden.

Durch die Ausweitung der Oberflächenmontage auf Leiterplatten ergab sich die Notwendigkeit auch mit Anschlußdrähten versehene Bausteine, wie z.B. E-Kern-Übertrager, Schalenkernspulen, Transformatoren, Drosseln und dergleichen an diese Technik anzupassen. Dabei müssen die Anschlußelemente einerseits für die Oberflächenmontage geeignet sein und andererseits eine sichere, elektrisch leitfähige Verbindung mit den zugeordneten Anschlußdrähten bzw. Spulendrähten gewährleisten. Bisher erfolgte diese Verbindung durch mehrmaliges Anwickeln der Anschlußdrahtenden am jeweiligen Anschlußelement.

Der Erfindung liegt die Aufgabe zugrunde, einen SMD-Baustein zu schaffen, bei welchem unter Verzicht auf das Anwickeln der Spulen- bzw. Anschlußdrahtenden eine sichere, elektrisch leitende Verbindung zwischen Anschlußdraht und Anschlußelement ge währleistet ist.

Diese Aufgabe wird bei einem gattungsgemäßen SMD-Baustein dadurch gelöst, daß
- das Anschlußelement im Endbereich zu einer U-förmigen Lasche zurückgebogen ist,
- der Anschlußdraht zwischen den Schenkeln der U-förmigen Lasche klemmend gehalten ist und daß
- im stirnseitigen Bereich der U-förmigen Lasche Anschlußelement und Anschlußdraht durch eine Schweißung miteinander verbunden sind.

Bei dem erfindungsgemäßen SMD-Baustein wird durch die U-förmige Lasche mit dem darin klemmenden Anschlußdraht und die nachfolgende stirnseitige Verschweißung eine hohe und reproduzierbare Verbindungsqualität erreicht. Durch den Verzicht auf das Anwickeln der Anschlußdrahtenden ergibt sich mit dem wesentlich einfacheren Klemmen eine leichte Automatisierbarkeit bei der Massenfertigung. Ein weiterer Vorteil des erfindungsgemäßen SMD-Bausteins ergibt sich dadurch, daß auch nachfolgende Lötungen, z.B. auf Leiterplatten, nicht zu einer Beeinträchtigung der geklemmten und verschweißten Verbindung zwischen Anschlußdraht und Anschlußelement führen können.

Gemäß einer bevorzugten Ausgestaltung der Erfindung ist das Anschlußelement zumindest im Innenbereich der U-förmigen Lasche verzinnt. Hierdurch ergibt sich dann beim Schweißen zusätzlich eine Weichlötung zwischen Anschlußdraht und Anschlußelement, die zu einer weiteren Steigerung der Verbindungsqualität führt.

Weiterhin hat es sich im Hinblick auf die Verbindungsqualität auch als vorteilhaft herausgestellt, wenn das Anschlußelement aus Zinnbronze besteht. Weist das Anschlußelement einen rechteckförmigen Querschnitt auf, so ist es sowohl für die Verbindung mit dem Anschlußdraht als auch für die spätere Oberflächenmontage besonders gut geeignet.

Im Hinblick auf geeignete Verbindungspartner haben sich Anschlußdrähte aus Kupfer als günstig herausgestellt. Der Anschlußdraht kann dabei auch als Kupferlackdraht ausgebildet sein, da der Lack sich beim Schweißen nicht störend auf die Verbindungsqualität auswirkt.

Ein Ausführungsbeispiel der Erfindung ist in der Zeichnung dargestellt und wird im folgenden näher beschrieben.

Es zeigt

Fig. 1 einen SMD-Baustein mit für die Ankontaktierung von Anschlußdrähten vorbereiteten Anschlußelementen,

Fig. 2 die klemmende Halterung eines Anschlußdrahtes in einem Anschlußelement des SMD-Bausteins gemäß Fig. 1,

Fig. 3 eine Draufsicht auf Anschlußdraht und Anschlußelement gemäß Fig. 2 vor der Schweißung und

Fig. 4 eine Draufsicht auf Anschlußdraht und Anschlußelement gemäß Fig. 3 nach der Schweißung.

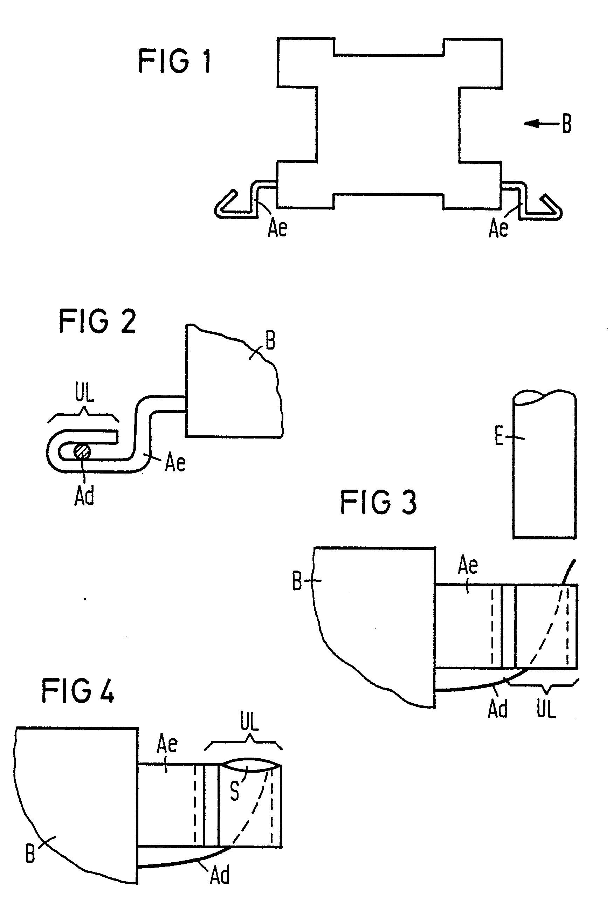

Fig. 1 zeigt eine Seitenansicht eines mit B bezeichneten SMD-Bausteins, bei welchem es sich um einen E-Kern-Übertrager handelt. Es ist zu erkennen, daß die Anschlußelemente Ae zunächst horizontal verlaufen, dann vertikal und anschließend wieder horizontal abgebogen sind und in ihrem Endbereich schließlich schräg zurückgebogen sind. In diesen zurückgebogenen Bereich werden dann die in Fig. 1 nicht näher dargestellten Anschlußdrähte eingelegt und durch Anbiegen des freien Endes der Anschlußelemente klemmend gehalten.

Die vorstehend erwähnte klemmende Halterung eines Anschlußdrahtes Ad in dem zu einer U-förmigen Lasche UL zurückgebogenen Endbereich eines Anschlußelementes Ae ist in Fig. 2 deutlich zu erkennen.

Fig. 3 zeigt eine Draufsicht auf das Anschlußelement Ae und den klemmend in der U-förmigen Lasche UL gehaltenenen Anschlußdraht Ae. Es ist ferner zu erkennen, daß in geringem Abstand zum stirnseitigen Bereich der U-förmigen Lasche eine mit E bezeichnete Elektrode angeordnet ist. Mit dieser Elektrode E werden gemäß Fig. 4 im stirnseitigen Bereich der U-förmigen Lasche UL das Anschlußelement Ae und der Anschlußdraht Ad durch eine mit S bezeichnete Schweißung miteinander verbunden. Der gemäß Fig. 3 über die U-förmige Lasche UL überstehende Anschlußdraht Ad wird beim Schweißprozeß bis zu der Stirnfläche der U-förmigen Lasche UL zurückgeschmolzen. Durch eine Verzinnung des Anschlußelementes Ae ergibt sich zusätzlich zum Schweißprozeß im nicht angeschmolzenen Bereich eine Lötung zwischen den Verbundpartnern.

Im dargestellten Ausführungsbeispiel wurde als Anschlußdraht Ad ein CuL-Draht Typ V mit einem Durchmesser von 0,08 mm verwendet. Für die Anschlußelemente Ae wurde CuSn6 mit verzinnter Oberfläche in den Abmessungen 0,6 mm breit und 0,2 bzw. 0,1 mm dick verwendet. Die Schweißung S wurde mit einer WIG-Elektrode E mit einem Schweißstrom von 3A und einer Schweißzeit von 0,2 s durchgeführt. Als Alternativverfahren zum WIG-Punktschweißen bietet sich insbesondere das Laserschweißen an. Weitere Schweißverfahren wie beispielsweise das Plasmaschweißen können jedoch ebenfalls zur Anwendung kommen.


**Ansprüche**

1. SMD-Baustein mit mindestens einem Anschlußelement und mindestens einem an das Anschlußelement ankontaktierten Anschlußdraht,
**dadurch gekennzeichnet,**
daß
- das Anschlußelement (Ae) im Endbereich zu einer U-förmigen Lasche (UL) zurückgebogen ist,
- der Anschlußdraht (Ad) zwischen den Schenkeln der U-förmigen Lasche (UL) klemmend gehalten ist und daß
- im stirnseitigen Bereich der U-förmigen Lasche (UL) Anschlußelement (Ae) und Anschlußdraht (Ad) durch eine Schweißung (S) miteinander verbunden sind.

2. SMD-Baustein nach Anspruch 1,
**dadurch gekennzeichnet,**
daß das Anschlußelement (Ae) zumindest im Innenbereich der U-förmigen Lasche (UL) verzinnt ist.

3. SMD-Baustein nach Anspruch 1 oder 2,
**gekennzeichnet durch,**
ein Anschlußelement (Ae) aus Zinnbronze.

4. SMD-Baustein nach einem der vorhergehenden Ansprüche,
**gekennzeichnet durch,**
ein Anschlußelement (Ae) mit rechteckförmigen Querschnitt.

5. SMD-Baustein nach einem der vorhergehenden Ansprüche,
**gekennzeichnet durch,**
einen Anschlußdraht (Ad) aus Kupfer.

6. SMD-Baustein nach Anspruch 5,
**gekennzeichnet durch,**
einen als Kupferlackdraht ausgebildeten Anschlußdraht (Ad).

FIG 1

B

Ae                    Ae

FIG 2

B

UL

Ae

Ad

E

FIG 3

Ae

B

Ad    UL

FIG 4

UL

Ae

S

B

Ad

Europäisches
Patentamt

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | US-A-4 553 123 (MURATA)<br>* Spalte 4, Zeilen 24-31; Figuren 4,10 * | 1,4 | H 01 F 15/10 |
| A | | 2,3,5,6 | |
| A | DE-A-2 148 534 (PLATHNER)<br>* Seite 3, Zeilen 25-32; Seite 4, Zeilen 1-2; Figuren 1-4 * | 1 | |

**RECHERCHIERTE SACHGEBIETE (Int. Cl.4)**

H 01 F 15/00
H 01 F 5/00
H 01 F 41/00

Der vorliegende Recherchenbericht wurde für alle Patentansprüche erstellt

| Recherchenort | Abschlußdatum der Recherche | Prüfer |
|---|---|---|
| DEN HAAG | 18-08-1988 | CERIBELLA G. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
.........................................................................
& : Mitglied der gleichen Patentfamilie, übereinstimmendes Dokument

EPO FORM 1503 03.82 (P0403)